# EUROPEAN PATENT SPECIFICATION

(11) **EP 4 365 930 B1**
(45) Date of publication and mention of the grant of the patent: **19.08.2026**
(21) Application number: 22911190.1
(22) Date of filing: 19.12.2022
(51) Int. Cl.: C23C 14/54, C23C 16/52, G06N 3/08, G06N 20/00, G05B 23/02, H10P 50/24

(54) **PROGRAM, INFORMATION PROCESSING METHOD, INFORMATION PROCESSING DEVICE, AND MODEL GENERATION METHOD**
PROGRAMM, INFORMATIONSVERARBEITUNGSVERFAHREN, INFORMATIONSVERARBEITUNGSVORRICHTUNG UND MODELLERZEUGUNGSVERFAHREN
PROGRAMME, PROCÉDÉ DE TRAITEMENT D'INFORMATIONS, DISPOSITIF DE TRAITEMENT D'INFORMATIONS ET PROCÉDÉ DE GÉNÉRATION DE MODÈLE

(30) Priority: 22.12.2021 JP 2021208357
(43) Date of publication of application: 08.05.2024
(73) Proprietor: SPP Technologies Co., Ltd., Tokyo 100-0003 (JP)
(72) Inventor: HIRAMURA, Tatsuo, Amagasaki-shi, Hyogo 660-0891 (JP)
(74) Representative: Cabinet Beaumont
(86) International application number: PCT/JP2022/046721
(87) International publication number: WO 2023/120488

(56) References cited:
- JP-A- 2002 346 367
- JP-A- 2006 210 728
- JP-A- 2009 253 087
- JP-A- 2011 517 806
- JP-A- 2012 199 365
- JP-A- 2018 041 217
- JP-A- 2021 518 674
- US-A1- 2008 208 385
- US-A1- 2020 083 080

## Description

### [Technical Field]

The present technique relates to a program related to processing of a semiconductor manufacturing equipment, an information processing method, an information processing device and a model generation method.

### [Background Art]

Monitoring methods for detecting abnormalities in semiconductor manufacturing equipment have conventionally been proposed. For example, a monitoring method described in Patent Document 1 determines an abnormality based on the gas temperature of a vacuum pump part of a semiconductor manufacturing equipment.

### [Prior Art Document]

### [Patent Document]

[Patent Document 1] Japanese Patent Application Laid-Open No. H5-9759

US20200083080 relates to a self-aware and correcting heterogenous platform incorporating integrated semiconductor processing modules, and to a method of using the same. US2008208385A1 relates to detection of an abnormality of semiconductor manufacturing apparatus, by predicting an opening of a pressure control valve provided in the vacuum exhaust path based on previous process data and cumulative film thickness, and by judging whether the opening of the pressure control valve thus predicted exceeds a predetermined threshold value.

### [Summary]

### [Technical Problem]

The program described in Patent Document 1 determines an abnormality of an exhaust system based only on the gas temperature, resulting in low accuracy of determining an abnormality of the exhaust system.

The present disclosure is made in view of such circumstances, and an object of this disclosure is to provide a program and the like that determines an abnormality in the exhaust system of the semiconductor manufacturing equipment with high accuracy.

### [Solution to Problem]

The invention is defined by the appended set of claims.

### [Advantageous Effects]

A program according to one embodiment of the present disclosure can determine an abnormality of the semiconductor manufacturing equipment with high accuracy.

### [Brief Description of Drawings]

FIG. 1 is a schematic diagram illustrating the rough configuration of a semiconductor manufacturing equipment.
FIG. 2 is a block diagram illustrating the configuration of an information processing device.
FIG. 3 is a block diagram illustrating the configuration of a server device.
FIG. 4 is an explanatory view illustrating a learning model.
FIG. 5 is an explanatory view illustrating a time-series data table.
FIG. 6 is a schematic diagram illustrating one example of a screen displayed by the information processing device.
FIG. 7 is a flowchart of a procedure for generating a learning model.
FIG. 8 is a flowchart of a processing procedure to be performed by the information processing device.
FIG. 9 is a block diagram illustrating the configuration of an information processing device according to a second embodiment.
FIG. 10 is a schematic diagram illustrating one example of a screen displayed on the information processing device according to the second embodiment.
FIG. 11 is a flowchart of a processing procedure to be performed by the information processing device according to the second embodiment.
FIG. 12 is a schematic diagram illustrating a rough configuration of a second semiconductor manufacturing equipment.
FIG. 13 is a flowchart of a procedure for generating a second learning model.
FIG. 14 is a table indicating comparison of the process data and the state of the equipment among an equipment activating state, an equipment idle state and a manufacturing process state.
FIG. 15 is a graph representing an example of variation of chamber pressure and an APC opening degree.

### [Detailed Description]

### First Embodiment

Specific examples of a program, an information processing device and the like according to a first embodiment will be described below with reference to the drawings.

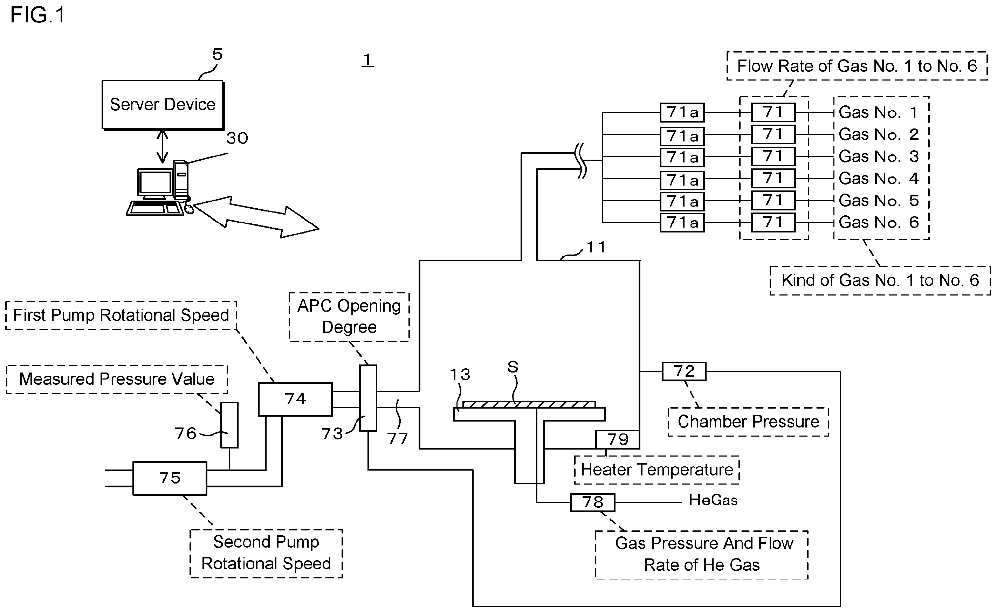

FIG. 1 is a schematic diagram illustrating the rough configuration of a semiconductor manufacturing equipment. A semiconductor manufacturing equipment 1 according to the present embodiment is an equipment that performs etching, a film deposition or the like by performing plasma treatment on a substrate of a semiconductor (including Micro Electro Mechanical Systems (MEMS)). The semiconductor manufacturing equipment 1 includes an information processing device 30. The information processing device 30 transmits and receives data and a learning model to and from a server device 5.

The semiconductor manufacturing equipment 1 is equipped with a chamber 11, a susceptor 13, gas supply sources (gas Nos. 1-6), a Mass Flow Controller (MFC) 71, a gas valve 71a, a vacuum gauge 72, an Automatic Pressure Controller (APC) 73, a first pump 74, a second pump 75, a vacuum gauge 76, an exhaust pipe 77, a pressure and flow meter 78 and a thermometer 79.

The gas valve 71a is disposed at each of the flow paths extending from the gas supply sources that are associated with the kinds of gas (gas No. 1 to No. 6) to the chamber 11. The MFC 71 is disposed at each of the flow paths extending from the gas supply sources to the gas valves 71a and controls the flow rate of each gas (gas Nos. 1-6 flow rate).

A substrate S is placed on the susceptor 13 provided within the chamber 11. Gas is supplied from the gas supply sources to the chamber while the substrate S is electrostatically adsorbed on an electrostatic chuck (not illustrated) provided on the susceptor 13, and the substrate S is subjected to plasma treatment such as etching or film deposition by a plasma source (not illustrated). The vacuum gauge 72 measures the pressure within the chamber 11 (chamber pressure).

The semiconductor manufacturing equipment 1 is heated by a heater (not illustrated) for heating wall surfaces in the chamber 11 and also is cooled by supplying He gas to the backside of the substrate S mounted on the susceptor 13. The pressure and flow meter 78 controls the pressure of and measures the flow rate of the He gas supplied to the backside of the substrate S. The thermometer 79 measures the temperature of the heater.

The APC 73 controls the pressure in the chamber 11 (chamber pressure) measured by the vacuum gauge 72 to a setting pressure by adjusting the degree of opening of the valve of itself (APC opening degree). The first pump 74 is for evacuating reaction products and is a turbo molecular pump, for example. The second pump 75 is a dry pump, for example, and is for supplementing the first pump 74. The first pump 74 and the second pump 75 are activated to evacuate the reaction products in the chamber 11 and reduce the pressure in the chamber 11. Hereinafter, the first pump 74, the second pump 75 and the exhaust pipe 77 are also referred to collectively as an exhaust system.

After completion of the process on the substrate S, the semiconductor manufacturing equipment 1 fully opens the valve contained in the APC to evacuate the residual gas and He gas in the chamber.

As such, the semiconductor manufacturing equipment 1 is equipped with various components and measuring instruments, and the information processing device 30 can acquire various process data related to the manufacturing process from these components and measuring instruments. In the example illustrated in the drawing, the information processing device 30 can acquire six kinds of gas Nos. 1-6 from the gas supply sources, the flow rates of gas Nos. 1-6 from the MFC 71, a chamber pressure from the vacuum gauge 72, an APC opening degree from the APC 73, a rotational speed of the motor of the first pump 74 from the first pump 74 (first pump rotational speed), a rotational speed of the motor of the second pump 75 from the second pump 75 (second pump rotational speed), gas pressure and flow rate of He gas from the pressure and flow meter 78, and a heater temperature from the thermometer 79, and can include them in the process data. In the present embodiment, the operating states of the first pump 74 and the second pump 75 correspond to the first pump rotational speed and the second pump rotational speed. The first pump rotational speed and the second pump rotational speed are controlled so as to achieve a constant speed.

The vacuum gauge 76 measures a pressure value (measured pressure value) of the exhaust pipe 77 located between the first pump 74 and the second pump 75. The information processing device 30 can acquire the measured pressure value from the vacuum gauge 76.

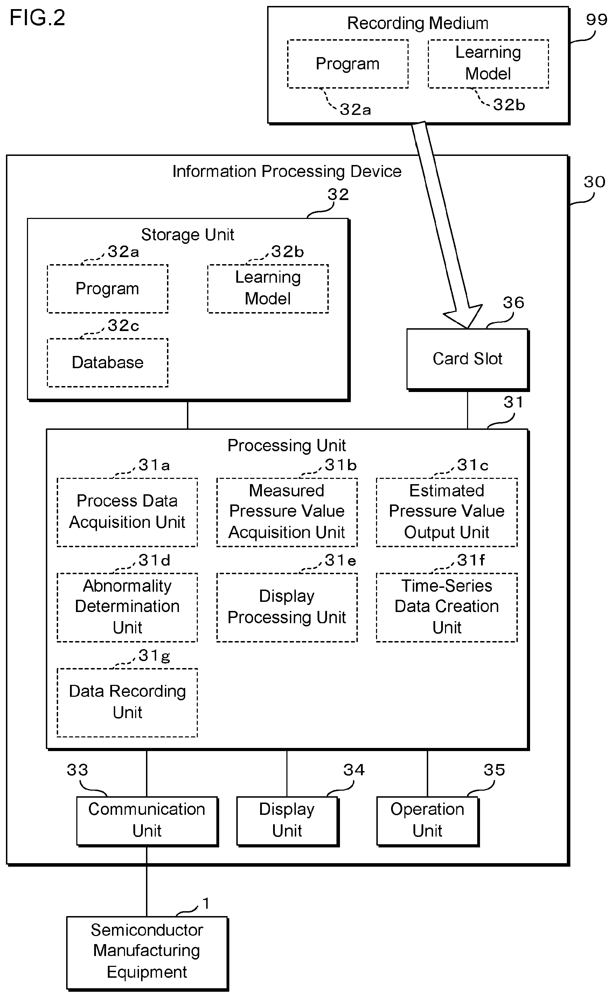

FIG. 2 is a block diagram illustrating the configuration of the information processing device. The information processing device 30 according to the present embodiment is composed of a processing unit 31, a storage unit 32, a communication unit 33, a display unit 34, an operation unit 35, a card slot 36 and the like. Though the information processing device 30 is configured as a single device in the present embodiment, multiple devices may be configured to perform distributed processing to achieve the function as the information processing device 30. Furthermore, the information processing device 30 may be integrated into the semiconductor manufacturing equipment 1.

The information processing device 30 determines whether or not the semiconductor manufacturing equipment 1 is in an abnormal state. The semiconductor manufacturing equipment 1 supplies gas to the chamber 11 and performs substrate process. When the semiconductor manufacturing equipment 1 continues to manufacture semiconductors, the reaction products (deposition) of the gas supplied to the chamber 11 are clogged in the piping, or the deterioration of the first pump 74 or the second pump 75 reduces the exhaust capacity, resulting in impairment of the reproducibility of the substrate process (plasma treatment). The information processing device 30 uses a learning model 32b to output a pressure value (estimated pressure value) of the exhaust system that is to be indicated by the vacuum gauge 76, assuming that the exhaust system is entirely normal. If the semiconductor manufacturing equipment 1 is in an abnormal state, the exhaust capacity of the exhaust system is reduced, so that the measured pressure value measured by the vacuum gauge 76 is higher than the estimated pressure value. The information processing device 30 determines whether or not the semiconductor manufacturing equipment 1 is in an abnormal state based on the difference between the measured pressure value and the estimated pressure value, and, if determining that a state is the abnormal state, reports it to the user of the semiconductor manufacturing equipment 1. Note that the information processing device 30 may determine whether or not the semiconductor manufacturing equipment 1 is in an abnormal state based on the first pump rotational speed or the second pump rotational speed. If the piping is clogged with reaction products (deposition) of the gas supplied to the chamber 11, the first pump or the second pump may not be able to maintain the rotational speed, resulting in speed reduction.

The information processing device 30 can determine that the semiconductor manufacturing equipment 1 is in an abnormal state in the case where the first pump rotational speed or the second pump rotational speed is smaller than a predetermined rotational speed.

The processing unit 31 is composed of an arithmetic processing unit such as a CPU (Central Processing Unit), a MPU (Micro-Processing Unit) or a GPU (Graphics Processing Unit). The processing unit 31 reads and executes the program stored in the storage unit 32 to perform various processing. In the present embodiment, the processing unit 31 reads and executes a program 32a and the learning model 32b stored in the storage unit 32 to thereby perform various processing including processing of outputting the estimated pressure value in the semiconductor manufacturing equipment 1, processing of determining whether or not the semiconductor manufacturing equipment 1 is in an abnormal state and processing of creating time-series data.

The storage unit 32 is composed of a mass storage device such as a hard disk or an SSD (Solid State Drive). The storage unit 32 stores various programs to be executed by the processing unit 31 and various data necessary for processing by the processing unit 31. In the present embodiment, the storage unit 32 stores the program 32a to be executed by the processing unit 31, the learning model 32b to be used for the processing performed by the execution of the program 32a and a database 32c for recording the data output from the processing unit 31.

In the present embodiment, the program 32a (program product) may be provided in the form recorded in a recording medium 99 such as a memory card. The information processing device 30 reads the program 32a from the recording medium 99 and stores it in the storage unit 32. Note that the program 32a may be written into the storage unit 32, for example, at the manufacturing stage of the information processing device 30. For example, the program 32a may be obtained by the writing device reading the program recorded in the recording medium 99 and writing it to the storage unit 32 of the information processing device 30. The program 32a may be provided in the form of distribution through a network.

The learning model 32b is a learning model that outputs an estimated pressure value based on process data acquired from the semiconductor manufacturing equipment 1. In the present embodiment, the learning model 32b outputs an estimated pressure value if process data is input including at least two of the chamber pressure, the APC opening degree, and the kind of gas No. 1 to No. 6 and the flow rate of gas No. 1 to No. 6 that are measured by various measurement instruments of the semiconductor manufacturing equipment 1.
. Note that the process data may include at least one of the first pump rotational speed and the second pump rotational speed, and may include heater temperature or pressure and flow rate of He gas. Though FIG. 2 illustrates only one learning model 32b, multiple learning models 32b may be stored in the storage unit 32. In addition, the learning model 32b may be stored in cloud provided by an external server. The details of the leaning model 32b are described below.

The database 32c records time-series data created by the processing unit 31. The details of the time-series data are described below. The data recording unit may record process data, measured pressure values and estimated pressure values as well as the time-series data.

The communication unit 33 is connected to the semiconductor manufacturing equipment 1 through a communication cable or the like, and transmits and receives various data to and from the semiconductor manufacturing equipment 1 through the communication cable. In the present embodiment, the communication unit 33 receives and acquires process data measured by each of the measurement instruments of the semiconductor manufacturing equipment 1 by communication through the communication cable. Note that the communication unit 33 may be configured to carry out wireless communication with the semiconductor manufacturing equipment 1.

The display unit 34 is composed of a liquid crystal display or the like and displays various images and characters based on the processing by the processing unit 31. The operation unit 35 accepts an operation by the user and reports the accepted operation to the processing unit 31. As an example, the operation unit 35 is an input device such as a mouse and a keyboard, and these input devices may be configured to be attachable to and detachable from the information processing device 30. As an example, the operation unit 35 may accept an operation by the user via an input device such as a touch panel installed on the surface of the display unit 34.

The card slot 36, removably loaded with the recording medium 99 such as a memory card, reads and writes data from and into the loaded recording medium 99. The card slot 36 reads data from the recording medium 99 and provides the processing unit 31 with the data, and also writes data provided from the processing unit 31 into the recording medium 99. In the present embodiment, the learning model 32b, which has been machine-trained in the server device 5 in advance, is recorded in the recording medium 99 and provided to the information processing device 30. The information processing device 30 reads the learning model 32b recorded in the recording medium 99 to the card slot 36 and stores it in the storage unit 32. Though the transmission and reception of data between the information processing device 30 and the server device 5 is performed via the recording medium 99 in the present embodiment, such data exchange between the information processing device 30 and the server device 5 may be performed through communication such as LAN (Local Area Network) or the Internet, not limited to the recording medium 99.

The storage unit 32 may be an external storage device connected to the information processing device 30. Furthermore, the information processing device 30 may be a multi-computer consisting of multiple computers or a virtual machine constructed virtually by software. Moreover, the information processing device 30 is not necessarily provided with a user interface such as the display unit 34 and the operation unit 35. Here, the administrator may operate the information processing device 30 through another device, for example.

The processing unit 31 of the information processing device 30 according to the present embodiment reads and executes the program 32a stored in the storage unit 32 to implement a process data acquisition unit 31a, a measured pressure value acquisition unit 31b, an estimated pressure value output unit 31c, an abnormality determination unit 31d, a display processing unit 31e, a time-series data creation unit 31f and a data recording unit 31g as functional parts in software. In addition, the processing unit 31 is equipped with a counter function regarding the time point when the semiconductor manufacturing equipment 1 starts manufacturing semiconductors as a starting point. As an alternative to the counter function, it may be provided with a clock function to measure the real time.

The process data acquisition unit 31a communicates with the semiconductor manufacturing equipment 1 through the communication unit 33 to perform processing of acquiring process data from the semiconductor manufacturing equipment 1. In the present embodiment, the process data includes data measured by the various measurement instruments provided in the semiconductor manufacturing equipment 1 as described above.

The measured pressure value acquisition unit 31b communicates with the semiconductor manufacturing equipment 1 through the communication unit 33 to perform processing of acquiring a measured pressure value measured by the vacuum gauge 76 provided in the semiconductor manufacturing equipment 1.

The estimated pressure value output unit 31c reads the learning model 32b from the storage unit 32, and inputs the process data acquired by the process data acquisition unit 31a to the learning model 32b to output an estimated pressure value.

The abnormality determination unit 31d determines whether or not the semiconductor manufacturing equipment 1 is in an abnormal state based on the acquired measured pressure value by the measured pressure value acquisition unit 31b and the estimated pressure value output by the estimated pressure value output unit 31c. Specifically, the abnormality determination unit 31d calculates the difference between the measured pressure value and the estimated pressure value, and determines that the semiconductor manufacturing equipment 1 is in an abnormal state in the case where the calculated difference is equal to or more than a predetermined value (threshold) set in advance. Note that the abnormality determination unit 31d may determine that a state is the abnormal state in the case where the difference is equal to or more than the threshold for a certain period of time continuously or a certain number of times.

The display processing unit 31e performs processing of displaying various images, characters or the like on the display unit 34. In the present embodiment, the display processing unit 31e displays the determination result of the abnormality determination unit 31d, for example. Furthermore, the display processing unit 31e may display the acquired process data, measured pressure value, estimated pressure value or time-series data recorded in the database 32c of the storage unit 32, which will be described later.

The time-series data creation unit 31f performs processing of creating time-series data. Specifically, the time-series data corresponds to the difference between the measured pressure value and the estimated pressure value associated with an elapsed time from when the semiconductor manufacturing equipment 1 starts manufacturing semiconductors. Note that the time-series data may contain the measured pressure value and the estimated pressure value. The difference may be made to correspond to the real time.

The data record unit 31g records the time-series data created by the time-series data creation unit 31f in the database 32c of the storage unit 32. Each time the time-series data creation unit 31f creates the time-series data, the data record unit 31 registers the time-series data in a time-series data table of the database 32c. The details of the time-series data table are described later.

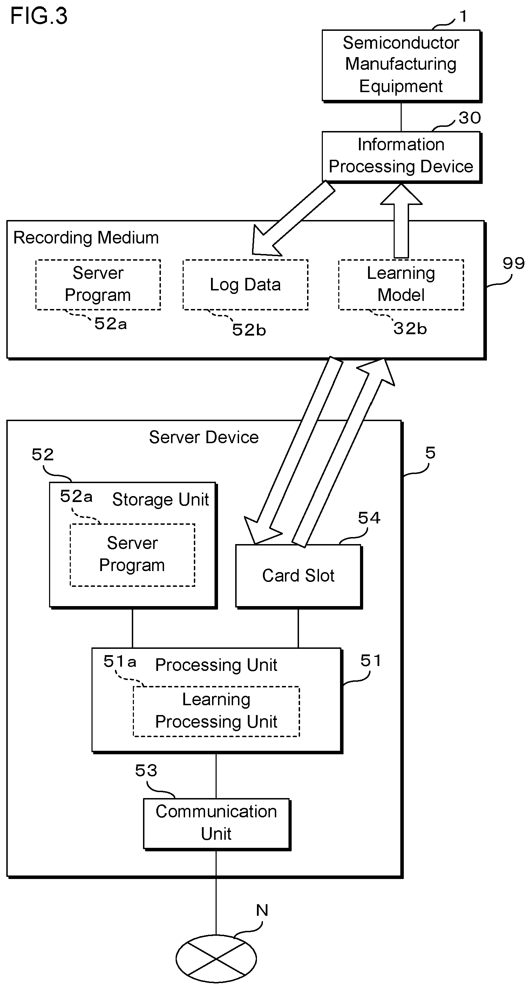

FIG. 3 is a block diagram illustrating the configuration of the server device 5 according to the present embodiment. The server device 5 according to the present embodiment is composed of a processing unit 51, a storage unit 52, a communication unit 53, a card slot 54 and the like. Though the present embodiment describes an example where processing is assumed to be performed by a single server device 5, processing may distributively be performed by a plurality of server devices 5. The processing performed by the server device 5 may be performed by the information processing device 30.

The processing unit 51 is composed of an arithmetic processing device such as a CPU, an MPU or a GPU. The processing unit 51 reads and executes a server program 52a stored in the storage unit 52 to perform various processing such as learning processing of the learning model 32b used by the information processing device 30.

The storage unit 52 is composed of a mass storage device such as a hard disk or an SSD. The storage unit 52 stores various programs to be executed by the processing unit 51 and various data necessary for processing by the processing unit 51. In the present embodiment, the storage unit 52 stores the server program 52a to be executed by the processing unit 51. In the present embodiment, the server program 52a is provided in the form recorded in the recording medium 99 such as a memory card, and the server device 5 reads the server program 52a from the recording medium 99 and stores it in the storage unit 52. Note that the server program 52a may be written into the storage unit 52, for example, at the manufacturing stage of the server device 5. For example, the server program 52a may be obtained by the writing device reading the program recorded in the recording medium 99 and writing it to the storage unit 52 of the server device 5. The server program 52a may be provided in the form of distribution through a network.

The communication unit 53 communicates with various devices via a network N including an internal LAN, a wireless LAN, the Internet or the like. The communication unit 53 transmits data provided from the processing unit 51 to another device and provides the processing unit 51 with data received from another device.

The card slot 54, removably loaded with the recording medium 99 such as a memory card, reads and writes data from and into the loaded recording medium 99. The card slot 54 reads data recorded in the recording medium 99 and also provides the processing unit 51 with the data and writes data provided from the processing unit 51 into the recording medium 99. In the present embodiment, the learning model 32b, which has been machine-trained by the server device 5, is written into the recording medium 99 through the card slot 56. This allows the server device 5 to offer the learning model 32b to the information processing device 30 of the semiconductor manufacturing equipment 1. In the present embodiment, log data 52b including multiple process data at the normal operation of the semiconductor manufacturing equipment 1 and pressure values measured by the vacuum gauge 76 when the exhaust system is normal, which are recorded by the information processing device 30, is written to the recording medium 99 so as to be offered, and the server device 5 reads and obtains the log data 52b from the recording medium 99 through the card slot 54 and uses it as training data for learning processing.

The storage unit 52 may be an external storage device connected to the server device 5. Furthermore, the server device 5 may be a multi-computer consisting of multiple computers or a virtual machine constructed virtually by software. In addition, the server device 5 is not limited to the above-described configuration, but may include, for example, an operation unit that accepts operation input, a display unit that displays images, or the like.

The processing unit 51 of the server device 5 according to the present embodiment reads and executes the server program 52a stored in the storage unit 52 to implement a learning processing unit 51a or the like as functional part in software. Note that the functional part is a functional part related to processing of generating the learning model 32b and the functional parts other than this are not illustrated and described.

The learning processing unit 51a performs processing of generating the learning model 32b by machine learning with training data. The learning processing unit 51a performs learning processing using training data prepared in advance by the administrator, developer or the like of this system at the first learning stage of the learning model 32b, that is, at the stage of first generating the learning model 32b. The training data used here can be created using data accumulated through the implementation of the semiconductor manufacturing equipment so far.

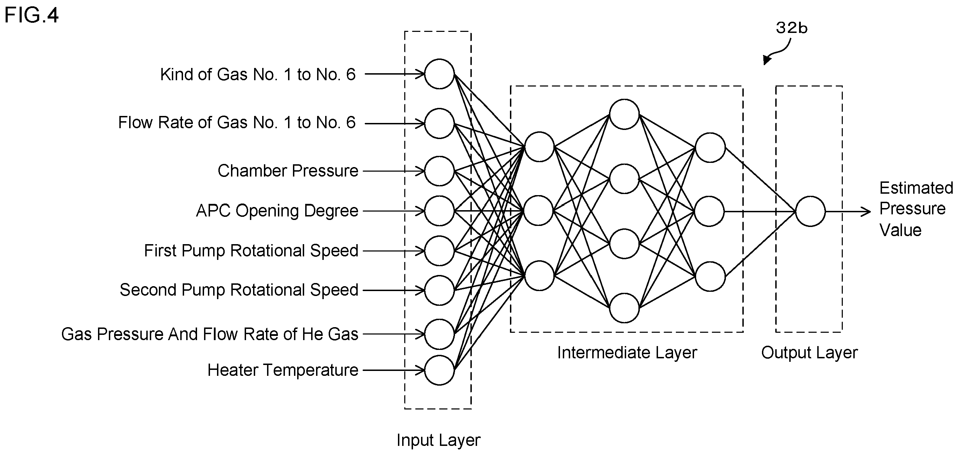

FIG. 4 is an explanatory view illustrating a learning model. The learning model 32b according to the present embodiment is generated by machine learning using a neural network, for example. Note that the machine learning may be performed by methods other than neural network. For example, various machine learning methods such as Long Short Term Memory (LSTM), Transformer, Support Vector Machine (SVM) or a k-neighbor method may be adopted.

An input layer included in the learning model 32b according to the present embodiment contains multiple neurons that accept input of various process data, and passes the input process data to an intermediate layer. The intermediate layer contains multiple neurons that extract the features of the process data and passes the extracted features to an output layer. The output layer contains a neuron that outputs an estimated pressure value and outputs an estimated pressure value based on the features output from the intermediate layer.

Note that the process data to be input to the learning model 32b may be time-series data.

In the machine learning of the learning model 32b according to the present embodiment, training data under the normal state can be used, with multiple process data under the normal state regarded as input information and with pressure values measured by the vacuum gauge 76 when the exhaust system is normal regarded as output information. Machine learning using the neural network is performed so as to output the same value as the pressure value measured by the vacuum gauge 76 under the normal state if process data under normal state is input. The process data and pressure values under the normal state are, for example, process data and pressure values acquired after the semiconductor manufacturing equipment 1 is installed, or at the test run after maintenance. The learning model 32b is trained using training data under the normal state including pairs of a large number of process data and pressure values.

Machine learning of the learning model 32b is not limited to the first time. The learning model 32b may be retrained using new training data or retrained adding new training data to the past training data as necessary. Here, the server device 50 may periodically transmit the retrained learning model 32b to the information processing device 30, and the processing unit 31 of the information processing device 30 may read the retrained learning model 32b.

In the present embodiment, the learning processing of the learning model 32b is performed in the server device 5 (see FIG. 3). The server device 5 performs machine learning according to the neural network using the above-mentioned training data prepared in advance to generate the learning model 32b. The learning model 32b generated by the server device 5 is provided to the information processing device 30 via the recording medium 99. Note that the learning model 32b may be trained in the information processing device 30.

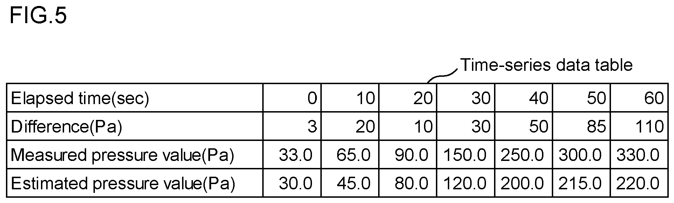

FIG. 5 is an explanatory view illustrating a time-series data table. The processing unit 31 of the information processing device 30, for example, acquires process data and a measured pressure value every 10 seconds to output an estimated pressure value. The processing unit 31 calculates the difference between the acquired measured pressure value and the estimated pressure value and registers, in the database 32c of the storage unit 32, the difference in association with the elapsed time from the start of manufacturing semiconductors to the acquisition of the process data and the measured pressure value. This processing is performed sequentially to create a time-series data table in the database 32c. As illustrated in FIG. 5, the measured pressure values and the estimated pressure values may further be registered in association with the elapsed time in the time-series data table.

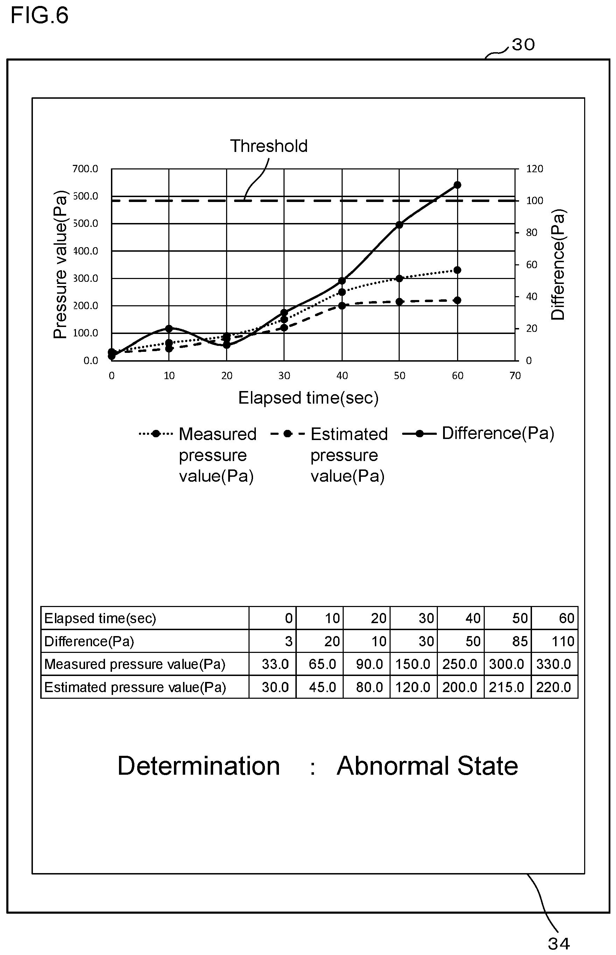

FIG. 6 is a schematic diagram illustrating one example of a screen displayed by the information processing device. On the display unit 34 of the information processing device 30, the time-series data table is displayed. In addition, the information processing device 30 may display a graph based on the time-series data table as illustrated in FIG. 6. The graph displayed on the display unit 34 represents, for example, the measured pressure value, the estimated pressure value and the difference, with the pressure value on the vertical axis and the elapsed time on the horizontal axis. In addition, the graph represents a threshold (e.g., 100 Pa) that serves as a criterion for determining the presence or absence of an abnormality relative to the difference. When the difference exceeds this threshold, this shows that the information processing device 30 determines an abnormal state of the semiconductor manufacturing equipment 1. In the present embodiment, the measured pressure value is indicated by the dotted line, the estimated pressure value is indicated by the dashed line, and the difference is indicated by the solid line.

Moreover, in the case where the processing unit 31 determines that a state is the abnormal state, the display unit 34 displays a warning message reporting the abnormal state to the user. Here, in the case where the processing unit 31 determines that a state is the abnormal state, the information processing device 30 may report the abnormal state to the user with changing the background color of the screen, turning on a lamp or outputting sound.

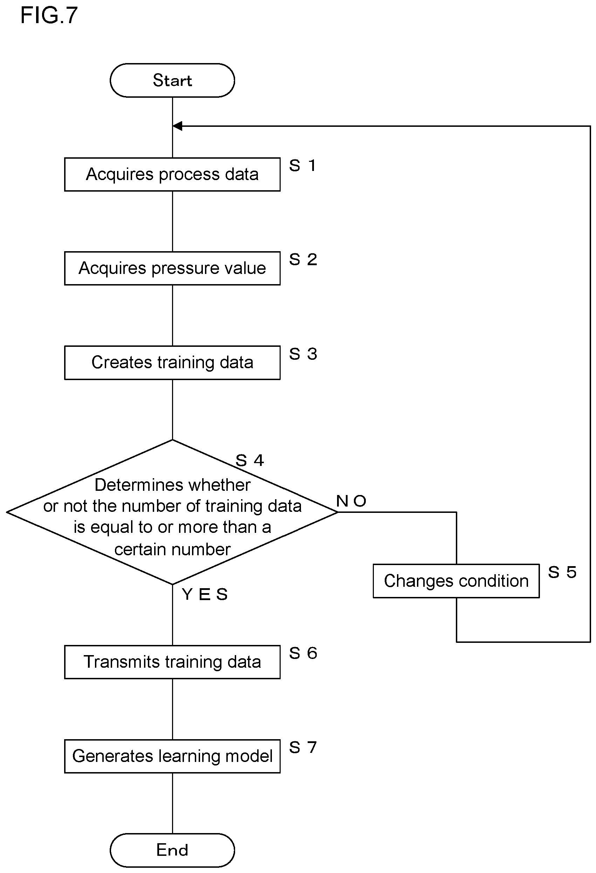

FIG. 7 is a flowchart of a procedure for generating a learning model. The information processing device 30 acquires process data from the semiconductor manufacturing equipment 1 under the normal state (S1) and further acquires a pressure value measured by the vacuum gauge 76 of the semiconductor manufacturing equipment 1 (S2). The information processing device 30 associates the process data with the pressure value to create training data (S3). The information processing device 30 determines whether or not the number of training data is equal to or more than a certain number required for generating the learning model 32b (S4). If the number of training data is less than the certain number (S4:NO), the information processing device 30 acquires process data again (S1) after changing a condition such as the kind of gas entering the chamber 1 or the flow rate of the gas (S5). If the number of training data is equal to or more than the certain number (S4: YES), the information processing device 30 transmits the training data to the server device 5 (S6) and causes the server device 5 to generate the learning model 32b (S7).

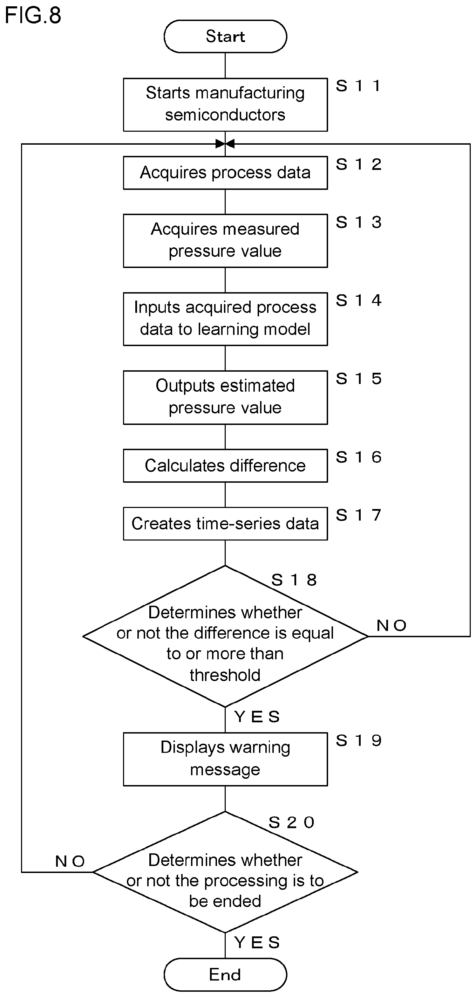

FIG. 8 is a flowchart of a processing procedure to be performed by the information processing device. The information processing device 30 causes the semiconductor manufacturing equipment 1 to start manufacturing semiconductors (S11). The information processing device 30 acquires process data from the semiconductor manufacturing equipment 1 (S12) and further acquires a measured pressure value from the vacuum gauge 76 of the semiconductor manufacturing equipment 1 (S13). The information processing device 30 inputs the acquired process data to the learning model 32b (S14) and outputs an estimated pressure value (S15). The information processing device 30 calculates the difference between the measured acquired pressure value and the estimated pressure value output (S16) and associates the calculated difference with the time to create time-series data (S17). The information processing device 30 determines whether or not the difference in the time-series data is equal to or more than the threshold (S18). If the difference is less than the threshold (S18: NO), the information processing device 30 returns the processing to S12. If the difference is equal to or more than the threshold (S18: YES), the information processing device 30 displays a warning message on the display unit 34 (S19) and determines whether or not the processing is to be ended (S20). The information processing device 30 ends the processing if an instruction to end the processing is input to the operation unit 35 (S20: YES). If the processing is not to be ended (S20: NO), the information processing device 30 returns the processing to S12 to acquire the process data again.

The processing by the program and the information processing device 30 according to the present embodiment can determine an abnormality of the semiconductor manufacturing equipment 1 with high accuracy. This makes it possible for the user of the semiconductor manufacturing equipment 1 to address the abnormal state. Visualization of the transition in the difference between the measured pressure value and the estimated pressure value allows the user to guess the cause of the abnormality.

### Second Embodiment

If the difference between the measured pressure value and the estimated pressure value is not equal to or more than a predetermined value (threshold), the information processing device 30 may predict the time when the difference becomes equal to or more than a predetermined value. The program, information processing device or the like according to the second embodiment will be described below with reference to the drawings. The same parts of the first embodiment of the configuration according to the second embodiment will be denoted by the same reference codes and the details will not be described here.

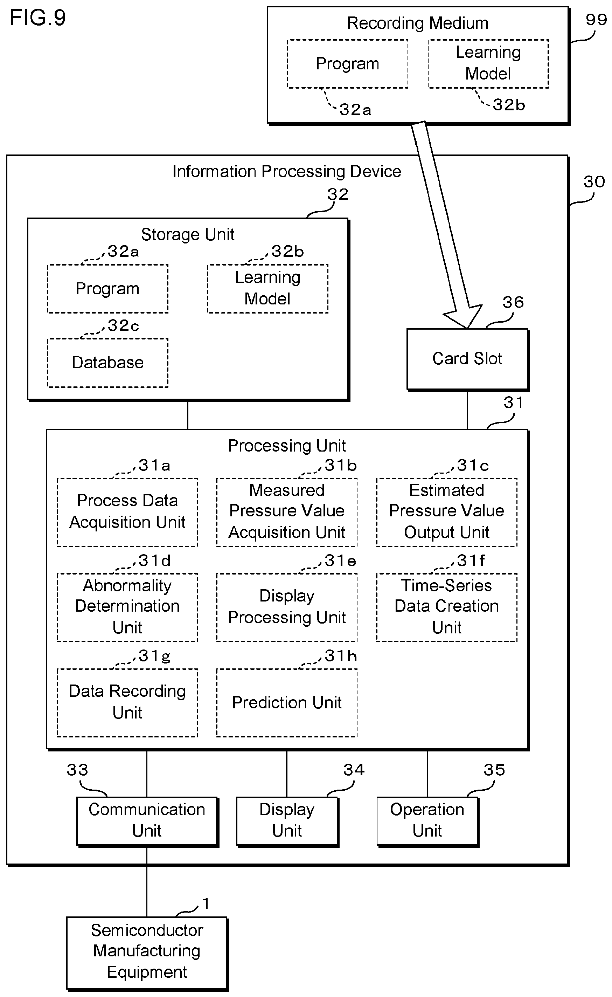

FIG. 9 is a block diagram illustrating the configuration of the information processing device according to the second embodiment. The information processing device 30 according to the present embodiment is equipped with a prediction unit 31h in addition to the functional parts according to the first embodiment. The prediction unit 31h predicts the time when the difference between the measured pressure value and the estimated pressure value becomes equal to or more than a threshold based on the time-series data recorded in the database 32c of the storage unit 32. Specifically, the prediction unit 31h calculates an approximation function representing the relationship between time and difference in time-series data using the least squares method or the maximum likelihood method, for example, to predict how many second(s) remain until the difference becomes equal to or more than the threshold, based on the approximation function, meaning that the semiconductor manufacturing equipment 1 becomes abnormal. Note that the information processing device 30 may predict the time when the semiconductor manufacturing equipment 1 becomes abnormal using a learning model such as seq2seq, LSTM or Transformer. Here, time-series data obtained over multiple periods are used as training data for generating the learning model.

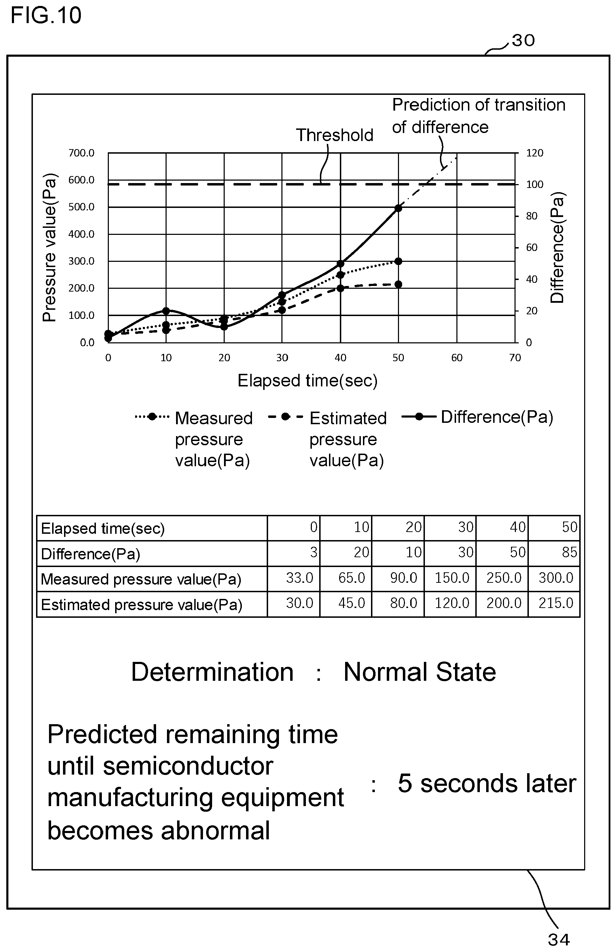

FIG. 10 is a schematic diagram illustrating one example of a screen displayed on the information processing device according to the second embodiment. If determining that the semiconductor manufacturing equipment 1 is not in the abnormal state, the information processing device 30 according to the present embodiment displays a predicted remaining time until the difference between the measured pressure value and the estimated pressure value becomes equal to or more than the threshold, and the semiconductor manufacturing equipment 1 becomes abnormal. In addition, as illustrated in FIG. 10, the prediction of the transition in the graph representing the difference may be displayed by a dot-dash line. Note that, if determining that the semiconductor manufacturing equipment 1 is in an abnormal state, the information processing device 30 displays a warning message to report the abnormal state to the user as in the first embodiment (see FIG. 6). If the difference and the amount of change in the transition of the difference are too small to predict the time when the difference becomes equal to more than the threshold, the prediction time is not displayed.

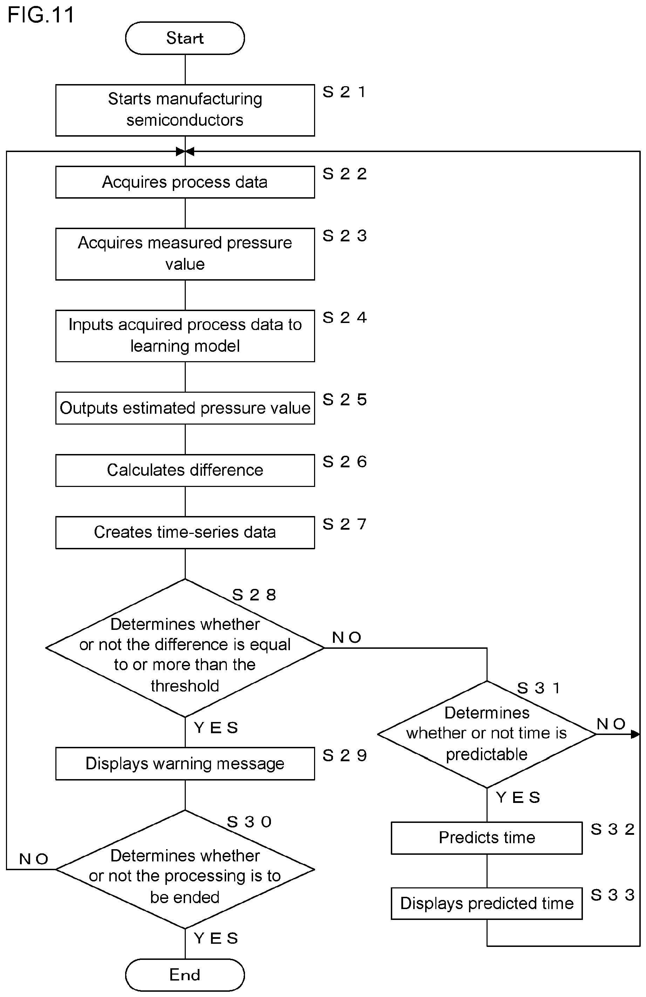

FIG. 11 is a flowchart of a processing procedure to be performed by the information processing device according to the second embodiment. The processing at S21-S30 is similar to that at S11-S20 of the first embodiment. If the difference between the measured pressure value and the estimated pressure value is less than the threshold (S28: NO), the information processing device 30 determines whether or not a remaining time until the semiconductor manufacturing equipment 1 becomes abnormal is predictable (S31). If the time is predictable (S31: YES), the information processing device 30 predicts the remaining time until the difference between the measured pressure value and the estimated pressure value becomes equal to or more than the threshold meaning that the semiconductor manufacturing equipment 1 becomes abnormal (S32), displays the predicted time on the display unit 34 (S33) and returns the processing to S22. If the time is not predictable (S31:NO), the information processing device 30 returns the processing to S22.

According to the program and the processing performed by the information processing device 30 in the present embodiment, it is possible to predict the time when the semiconductor manufacturing equipment 1 becomes abnormal if there is a sign of becoming an abnormal state. This allows the user of the semiconductor manufacturing equipment 1 to prepare for or avoid abnormal states.

### Third Embodiment

The server device 5 according to a third embodiment fine-tunes a learning model 32b (first learning model) trained using first training data including pressure values (first pressure values) acquired from the vacuum gauge 76 of a semiconductor manufacturing equipment 1 (first semiconductor manufacturing equipment) to generate a second learning model. When a semiconductor manufacturing equipment is installed at the location of its use, the type of the pump or the layout or length of the exhaust pipe change depending on the location of its use. The information processing device according to the present embodiment uses the second learning model generated by fine-tuning the first learning model to output an estimated pressure value of the semiconductor manufacturing equipment whose type of the pump, or layout or length of the exhaust pipe is changed.

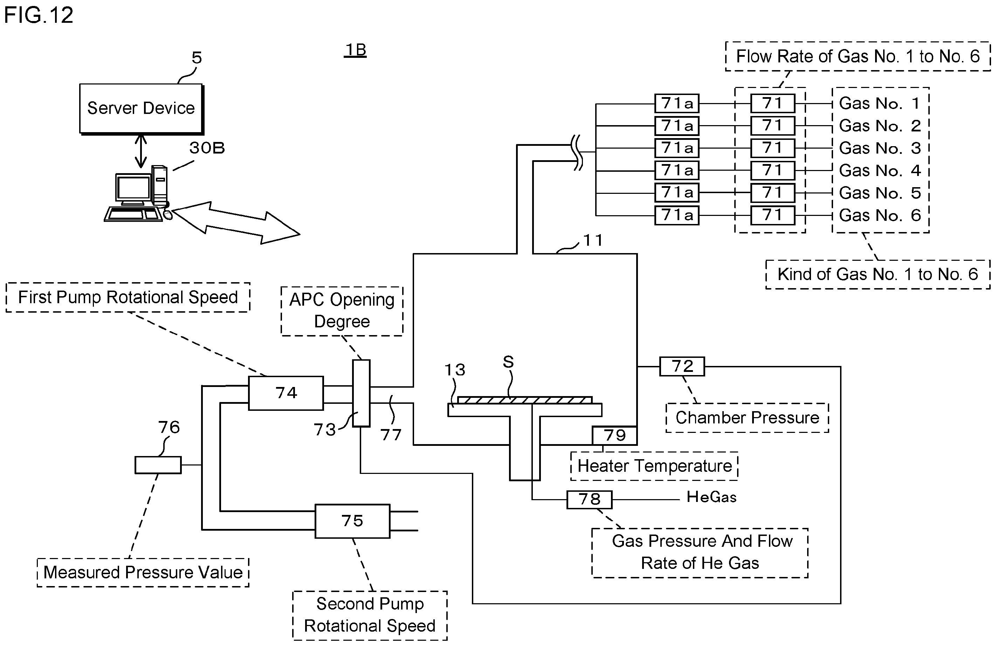

FIG. 12 is a schematic diagram illustrating the rough configuration of a second semiconductor manufacturing equipment. The second learning model is used to output an estimated pressure value of a second semiconductor manufacturing equipment 1B, which is different from the semiconductor manufacturing equipment 1 (the first semiconductor manufacturing equipment). The second semiconductor manufacturing equipment 1B, for example, may not be able to output a correct estimated pressure value using the learning model 32b because it is different from the first semiconductor manufacturing equipment in the type of the first pump 74 and the second pump 75 which are equipped or the layout or length of the exhaust pipe 77 as illustrated in FIG. 12. The server device 5 finely tunes the learning model 32b using the second training data, with multiple process data under the normal state regarded as input information and pressure values (second pressure value) measured by the vacuum gauge 76 of the second semiconductor manufacturing equipment 1B when the exhaust system is normal regarded as output information to generate the second learning model. Though the second training data used when the second learning model is generated is less than the training data (first training data) used when the learning model 32b is generated, the second training data more than the first training data may be used.

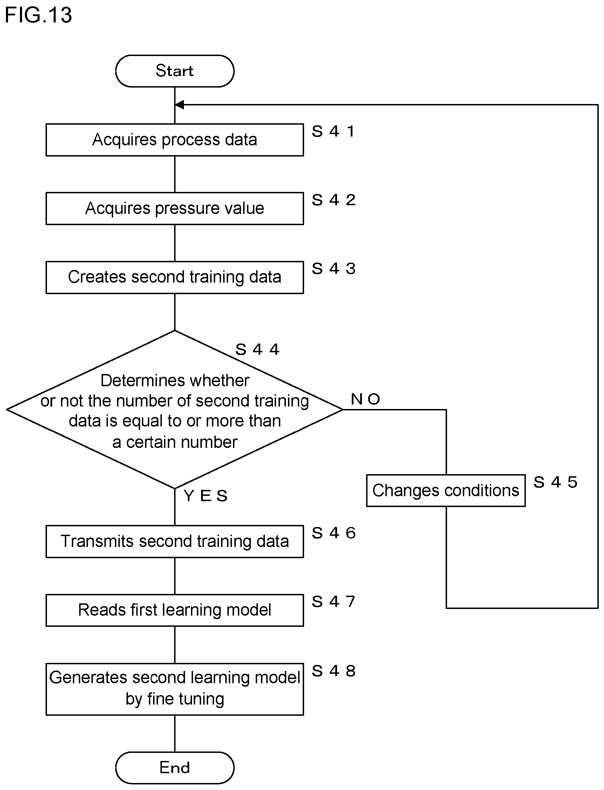

FIG. 13 is a flowchart of a procedure for generating the second learning model. An information processing device 30B of the second semiconductor manufacturing equipment 1B (see FIG.12) acquires process data from the second semiconductor manufacturing equipment 1B (S41) and further acquires a pressure value from the vacuum gauge 76 of the second semiconductor manufacturing equipment 1B (S42). The information processing device 30B creates the second training data by associating the process data with the pressure value (S43). The information processing device 30B determines whether or not the number of second training data is equal to or more than a certain number required for fine tuning (S44), and, if the number of second training data is less than the certain number (S44: NO), changes the conditions such as the kind or a flow rate of gas that enters the chamber 11 of the second semiconductor manufacturing equipment 1B (S45) and acquires the process data again (S41). If the number of second training data is equal to or more than the certain number (S44: YES), the information processing device 30B transmits the second training data to the server device 5 (S46) to cause the server device 5 to read the first learning model (S47) and generate the second learning model by fine tuning (S48).

According to the model generation method of the present embodiment, it is possible to quickly provide a learning model that outputs an estimated pressure value of the semiconductor manufacturing equipment having a different pump type or a different layout or length of the exhaust pipe.

### Modified Example

Though in each of the above-mentioned embodiments, the processing unit 31 of the information processing device 30 determines whether or not the exhaust system is in an abnormal state by comparing the estimated pressure value with the measured pressure value, the determination method is not limited thereto. A range of the pressure value of the exhaust system assumed when the exhaust system is normal is stored in the storage unit 32 of the information processing device 30, and the processing unit 31 may determine that the exhaust system is in an abnormal state if the estimated pressure value is outside the range of the pressure value stored in the storage unit 32.

Though in each of the above-mentioned embodiments, the processing unit 31 of the information processing device 30 determines the abnormality of the exhaust system in a manufacturing process state (during the manufacturing process) where gas is supplied to the chamber, the timing of the determination is not limited thereto. The processing unit 31 may determine the abnormality of the exhaust system in an equipment idle state before start of the manufacturing process. Here, the process data includes data or measured values or the like obtained from various components or measuring instruments in the equipment idle state.

### Supplementary Description

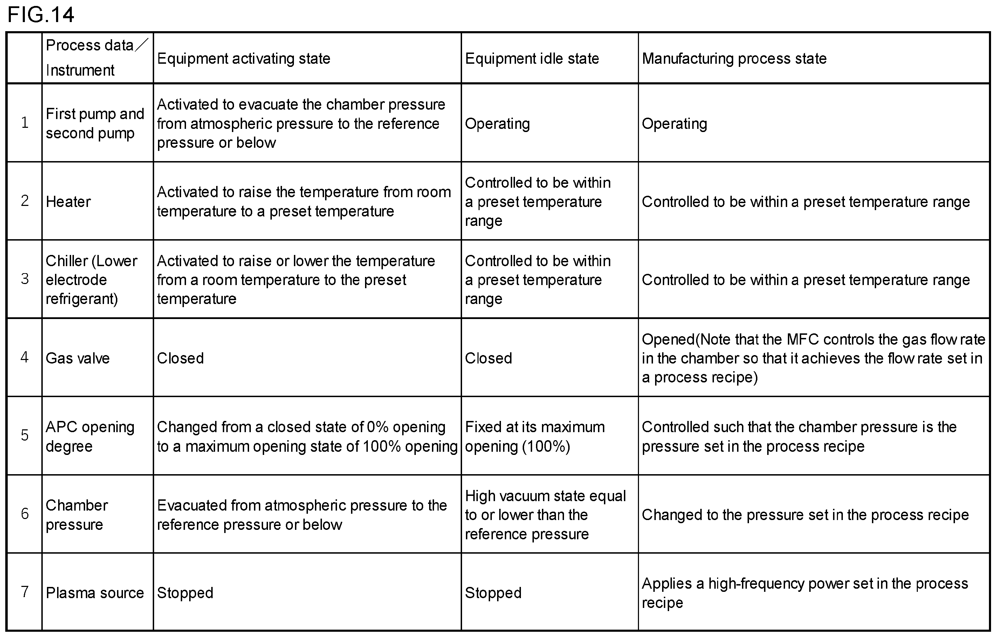

Supplementary description about the states of the components is made below. FIG. 14 is a table indicating comparison of the process data and the state of the components among an equipment activating state, an equipment idle state and a manufacturing process state. The equipment activating state is a state occurring when the chamber is being evacuated to a predetermined reference pressure (base pressure) or below. The first pump 74 and the second pump 75 are activated to evacuate the chamber from atmospheric pressure to the reference pressure or below. The heater is activated to raise the temperature from room temperature to a preset temperature. A chiller (lower electrode refrigerant), which cools the backside of the substrate S, is activated to raise or lower the temperature from room temperature to the preset temperature. The gas valve 71a is closed. The APC opening degree is changed from a closed state of 0% opening to a maximum opening state of 100% opening. The chamber is evacuated from atmospheric pressure to the reference pressure or below and the chamber pressure fluctuates. The plasma source is stopped.

In the equipment idle state, the first pump 74 and the second pump 75 are operating, and the heater and the chiller are controlled to be within a preset temperature range. The gas valve 71a is closed, and the APC opening degree is fixed at its maximum opening (100%). The chamber pressure is a high vacuum state equal to or lower than the reference pressure, and the plasma source is stopped.

In the manufacturing process state, the first pump 74 and the second pump 75 are operating, and the heater and the chiller are controlled to be within a preset temperature range. The gas valve is opened. Note that the MFC controls the gas flow rate in the chamber so that it achieves the flow rate set in a process recipe indicating a substrate process condition. The APC opening degree is controlled and varied such that the chamber pressure is the pressure set in the process recipe. The chamber pressure is changed to the pressure set in the process recipe. The plasma source applies high-frequency power set in the process recipe.

As shown in FIG. 14, the fluctuation of process data is small in the equipment idle state. This allows the processing unit 31 of the information processing device 30 to determine whether or not the exhaust system is in an abnormal state with high accuracy using a method for determining whether or not the estimated pressure value is within the range of the pressure value stored in the storage unit 32 as well. Note that in the manufacturing process state as well, the processing unit 31 may determine that the exhaust system is in the abnormal state if the estimated pressure value is outside the range of the pressure value stored in the storage unit 32.

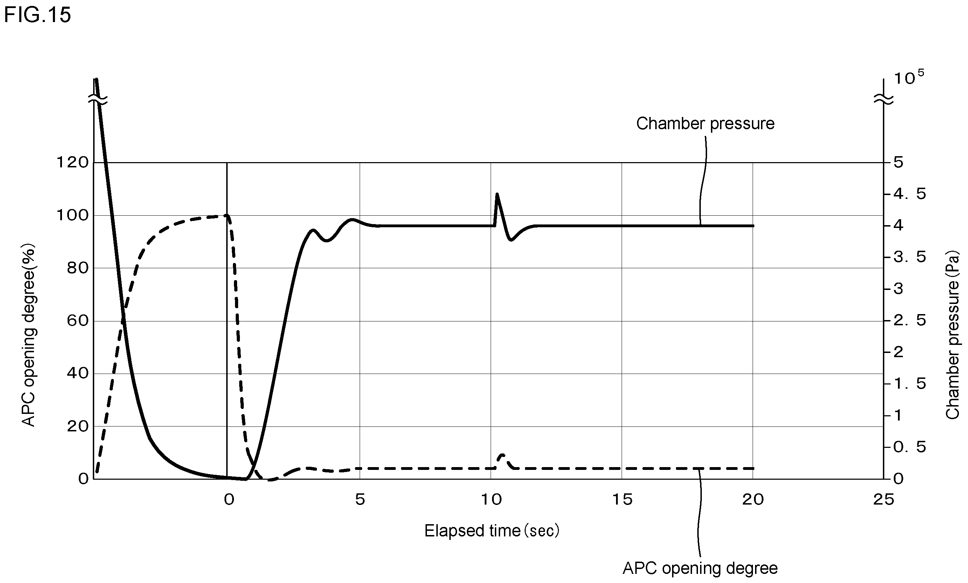

The supplementary description about the APC opening degree is made below. FIG. 15 is a graph representing an example of variation of the chamber pressure and the APC opening degree. In the case where the semiconductor manufacturing equipment 1 executes evacuation of reducing the chamber pressure in the equipment activating state to thereby make the chamber pressure equal to or lower than a predetermined reference pressure value, the equipment goes to the equipment idle state. Subsequently, the semiconductor manufacturing equipment 1 receives input of instruction of starting the semiconductor manufacturing process and changes the APC opening degree to increase the chamber pressure to the pressure (setting pressure) set in the process recipe, to goes to the manufacturing process state.

The horizontal axis of the graph in FIG. 15 indicates the elapsed time (seconds) since the instruction of starting the semiconductor manufacturing process was input, and the vertical axis indicates the APC opening degree (%) or the chamber pressure (Pa). In the graph in FIG. 15, the transition of the chamber pressure is indicated by a solid line while the transition of the APC opening degree is indicated by a dashed line.

During the equipment activating state, the APC opening degree is controlled from opening 0% to opening 100%, to thereby reduce the chamber pressure from atmospheric pressure to the reference pressure or below, so that the semiconductor manufacturing equipment goes to the equipment idle state. If going from the equipment idle state to the manufacturing process state, the semiconductor manufacturing equipment 1 controls the APC opening degree to approximately 5%, for example, as illustrated in Fig. 15, to keep the chamber pressure to setting pressure. In the example illustrated in FIG. 15, the setting pressure is 4 Pa. In addition, the chamber pressure may fluctuate from the setting pressure in the vicinity of 10 to 11 seconds in the graph represented in FIG. 15. The chamber pressure fluctuates in the case where the plasma source starts to apply high-frequency power, for example. In the case where the chamber pressure fluctuates, the semiconductor manufacturing equipment 1 controls the APC so that the chamber pressure achieves a specified pressure, to change the APC opening degree. Accordingly, the APC opening degree included in the process data to be input to the learning model is variable data.

It is to be understood that the embodiments disclosed here is illustrative in all respects and not restrictive.

### [Description of Reference Numerals]

- 1: semiconductor manufacturing equipment
- 5: server device
- 11: chamber
- 13: susceptor
- 30: Information processing device
- 31: processing unit
- 31a: process data acquisition unit
- 31b: measured pressure value acquisition unit
- 31c: estimated pressure value output unit
- 31d: abnormality determination unit
- 31e: display processing unit
- 31f: time-series data creation unit
- 31g: data recording unit
- 31h: prediction unit
- 32: storage unit
- 32a: program
- 32b: learning model
- 32c: database
- 33: communication unit
- 34: display unit
- 35: operation unit
- 36: card slot
- 51: processing unit
- 51a: learning processing unit
- 52: storage unit
- 53: communication unit
- 54: card slot
- 71: MFC
- 71a: gas valve
- 72: vacuum gauge
- 73: APC
- 74: first pump
- 75: second pump
- 76: vacuum gauge
- 77: exhaust pipe
- 78: pressure and flowmeter
- 99: recording medium

## Claims

1. A program causing a computer to execute processing of: acquiring process data including at least two of chamber pressure, a valve opening degree of an automatic pressure control device and a kind and a flow rate of gas supplied to a semiconductor manufacturing equipment (1);
inputting the process data to a learning model (32b) to output an estimated pressure value, the learning model (32b) being trained so as to output an estimated pressure value, that is to be indicated by a vacuum gauge (76), within an exhaust pipe (77) located between first and second pumps (74, 75) of an exhaust system of the semiconductor manufacturing equipment (1) assuming that the exhaust system is entirely normal if process data is input;
and determining whether or not a state of the exhaust system is an abnormal state based on the estimated pressure value within the exhaust pipe (77).

2. The program according to claim 1, causing the computer to execute processing of:
acquiring a measured pressure value measured by the vacuum gauge (76) provided in the semiconductor manufacturing equipment (1);
determining whether or not the state of the exhaust system is an abnormal state based on the estimated pressure value and the measured pressure value;
continuously acquiring a difference between the estimated pressure value and the measured pressure value;
creating time-series data in which the difference and time are associated with each other;
displaying the time-series data on a display unit;_and
predicting a time when the difference becomes equal to or more than a predetermined value based on the time-series data.

3. The program according to claim 1 or 2 causing the computer to execute processing of acquiring the process data during an equipment idle state before a manufacturing process of supplying gas to the semiconductor manufacturing equipment (1).

4. An information processing method comprising: acquiring process data including at least two of chamber pressure, a valve opening degree of an automatic pressure control device and a kind and a flow rate of gas supplied to a semiconductor manufacturing equipment (1);
inputting the process data to a learning model (32b) to output an estimated pressure value, the learning model (32b) being trained so as to output an estimated pressure value, that is to be indicated by a vacuum gauge (76), within an exhaust pipe (77) located between first and second pumps (74, 75) of an exhaust system of the semiconductor manufacturing equipment (1) assuming that the exhaust system is entirely normal if process data is input; and
determining whether or not a state of the exhaust system is an abnormal state based on the estimated pressure value within the exhaust pipe (77).

5. The information processing method according to claim 4, comprising:
acquiring a measured pressure value measured by the vacuum gauge (76) provided in the semiconductor manufacturing equipment (1);
determining whether or not the state of the exhaust system is an abnormal state based on the estimated pressure value and the measured pressure value;
continuously acquiring a difference between the estimated pressure value and the measured pressure value;
creating time-series data in which the difference and time are associated with each other;
displaying the time-series data on a display unit; and
predicting a time when the difference becomes equal to or more than a predetermined value based on the time-series data.

6. The information processing method according to claim 4 or 5, comprising acquiring the process data during an equipment idle state before a manufacturing process of supplying gas to the semiconductor manufacturing equipment (1).

7. An information processing device, comprising: a process data acquisition unit (31a) that acquires process data including at least two of chamber pressure, a valve opening degree of an automatic pressure control device and a kind and a flow rate of gas supplied to a semiconductor manufacturing equipment (1);
an estimated pressure value output unit (31c) that inputs the process data to a learning model (32b) to output an estimated pressure value, the learning model (32b) being trained so as to output an estimated pressure value, that is to be indicated by a vacuum gauge (76), within an exhaust pipe (77) located between first and second pumps (74, 75) of an exhaust system of the semiconductor manufacturing equipment (1) assuming that the exhaust system is entirely normal if process data is input; and
an abnormality determination unit (31d) that determines whether or not a state of the exhaust system is an abnormal state based on the estimated pressure value within the exhaust pipe (77).

8. The information processing device according to claim 7, comprising:
a measured pressure value acquisition unit (31b) that acquires a measured pressure value measured by the vacuum gauge (76) provided in the semiconductor manufacturing equipment (1);
the abnormality determination unit (31d) that determines whether or not the state of the exhaust system is an abnormal state based on the estimated pressure value and the measured pressure value;
a difference acquisition unit that continuously acquires a difference between the estimated pressure value and the measured pressure value;
a time-series data creation unit (31f) that creates time-series data in which the difference and time are associated with each other;
a display unit on which the time-series data is explained; and
a time prediction unit (31h) that predicts a time when the difference becomes equal to or more than a predetermined value based on the time-series data.

9. The information processing device according to claim 7 or 8, comprising the process data acquisition unit (31a) that acquires the process data during an equipment idle state before a manufacturing process of supplying gas to the semiconductor manufacturing equipment (1).

10. A model generation method for generating the learning model (32b) of any of claims 1, 4 or 7, comprising:
acquiring a first pressure value of a vacuum gauge (76) provided within an exhaust pipe (77) located between first and second pumps (74, 75) of an exhaust system of a first semiconductor manufacturing equipment (1);
acquiring first training data including process data including at least two of chamber pressure, a valve opening degree of an automatic pressure control device and a kind and a flow rate of gas supplied to the first semiconductor manufacturing equipment (1) and the acquired first pressure value;
generating, based on the acquired first training data, the learning model (32b) that outputs an estimated pressure value, that is to be indicated by the vacuum gauge (76) assuming that the exhaust system of the first semiconductor manufacturing equipment (1) is entirely normal if process data including at least two of chamber pressure, a valve opening degree of an automatic pressure control device and a kind and a flow rate of gas supplied to the first semiconductor manufacturing equipment (1) is input.

11. The model generation method for generating the learning model (32b) according to claim 10 comprising:
acquiring a second pressure value of a vacuum gauge (76) provided within an exhaust pipe (77) located between first and second pumps (74, 75) of an exhaust system of a second semiconductor manufacturing equipment (1B);
acquiring second training data including process data including at least two of chamber pressure, a valve opening degree of an automatic pressure control device and a kind and a flow rate of gas supplied to the second semiconductor manufacturing equipment (1B) and the acquired second pressure value, wherein the second training data is smaller in quantity than the first training data; and
fine-tuning the first learning model (32b) based on the acquired second training data to generate a second learning model (32b) that outputs an estimated pressure value, that is to be indicated by the vacuum gauge (76) of the second semiconductor manufacturing equipment (1B) assuming that the exhaust system of the second semiconductor manufacturing equipment (1B) is entirely normal if process data including at least two of chamber pressure, a valve opening degree of an automatic pressure control device and a kind and a flow rate of gas supplied to the second semiconductor manufacturing equipment (1B) is input.

## Patentansprüche

1. Ein Programm, das einen Computer veranlasst, eine Verarbeitung des Folgenden durchzuführen:
Erfassen von Prozessdaten, die wenigstens zwei aufweisen von Kammerdruck, einem Ventilöffnungsgrad einer automatischen Druckregeleinrichtung und einer Art und einer Durchflussrate von Gas, das einer Halbleiterfertigungsanlage (1) zugeführt wird;
Eingeben der Prozessdaten in ein Lernmodell (32b) zum Ausgeben eines geschätzten Druckwerts, wobei das Lernmodell (32b) so trainiert ist, dass es einen geschätzten Druckwert ausgibt, der von einem Vakuummessgerät (76) innerhalb eines Abgasrohrs (77), das zwischen ersten und zweiten Pumpen (74, 75) eines Abgassystems der Halbleiterfertigungsanlage (1) angeordnet ist, angezeigt werden soll, unter der Annahme, dass das Abgassystem vollständig normal ist, wenn Prozessdaten eingegeben werden; und
Bestimmen, ob ein Zustand des Abgassystems ein abnormaler Zustand ist oder nicht, basierend auf dem geschätzten Druckwert innerhalb des Abgasrohrs (77).

2. Das Programm nach Anspruch 1, das den Computer veranlasst, eine Verarbeitung des Folgenden durchzuführen:
Erfassen eines gemessenen Druckwerts, der von dem Vakuummessgerät (76) gemessen wird, das in der Halbleiterfertigungsanlage (1) vorgesehen ist;
Bestimmen, ob der Zustand des Abgassystems ein abnormaler Zustand ist oder nicht, basierend auf dem geschätzten Druckwert und dem gemessenen Druckwert;
kontinuierliches Erfassen einer Differenz zwischen dem geschätzten Druckwert und dem gemessenen Druckwert;
Erstellen von Zeitreihendaten, in denen die Differenz und die Zeit einander zugeordnet sind;
Anzeigen der Zeitreihendaten auf einer Anzeigeeinheit; und
Vorhersagen eines Zeitpunkts, zu dem die Differenz gleich einem vorbestimmten Wert oder größer als dieser wird, basierend auf den Zeitreihendaten.

3. Das Programm nach Anspruch 1 oder 2, das den Computer veranlasst, eine Verarbeitung des Erfassens der Prozessdaten während eines Anlagen-Leerlaufzustands vor einem Fertigungsprozess des Zuführens von Gas zu der Halbleiterfertigungsanlage (1) durchzuführen.

4. Ein Informationsverarbeitungsverfahren, das Folgendes aufweist:
Erfassen von Prozessdaten, die wenigstens zwei aufweisen von Kammerdruck, einem Ventilöffnungsgrad einer automatischen Druckregeleinrichtung und einer Art und einer Durchflussrate von Gas, das einer Halbleiterfertigungsanlage (1) zugeführt wird;
Eingeben der Prozessdaten in ein Lernmodell (32b) zum Ausgeben eines geschätzten Druckwerts, wobei das Lernmodell (32b) so trainiert ist, dass es einen geschätzten Druckwert ausgibt, der von einem Vakuummessgerät (76) innerhalb eines Abgasrohrs (77), das zwischen ersten und zweiten Pumpen (74, 75) eines Abgassystems der Halbleiterfertigungsanlage (1) angeordnet ist, angezeigt werden soll, unter der Annahme, dass das Abgassystem vollständig normal ist, wenn Prozessdaten eingegeben werden; und
Bestimmen, ob ein Zustand des Abgassystems ein abnormaler Zustand ist oder nicht, basierend auf dem geschätzten Druckwert innerhalb des Abgasrohrs (77).

5. Das Informationsverarbeitungsverfahren nach Anspruch 4, das Folgendes aufweist:
Erfassen eines gemessenen Druckwerts, der von dem Vakuummessgerät (76) gemessen wird, das in der Halbleiterfertigungsanlage (1) vorgesehen ist;
Bestimmen, ob der Zustand des Abgassystems ein abnormaler Zustand ist oder nicht, basierend auf dem geschätzten Druckwert und dem gemessenen Druckwert;
kontinuierliches Erfassen einer Differenz zwischen dem geschätzten Druckwert und dem gemessenen Druckwert;
Erstellen von Zeitreihendaten, in denen die Differenz und die Zeit einander zugeordnet sind;
Anzeigen der Zeitreihendaten auf einer Anzeigeeinheit; und
Vorhersagen eines Zeitpunkts, zu dem die Differenz gleich einem vorbestimmten Wert oder größer als dieser wird, basierend auf den Zeitreihendaten.

6. Das Informationsverarbeitungsverfahren nach Anspruch 4 oder 5, das Erfassen der Prozessdaten während eines Anlagen-Leerlaufzustands vor einem Fertigungsprozess des Zuführens von Gas zu der Halbleiterfertigungsanlage (1) aufweist.

7. Eine Informationsverarbeitungsvorrichtung, die Folgendes aufweist:
eine Prozessdaten-Erfassungseinheit (31a), die Prozessdaten erfasst, die wenigstens zwei aufweisen von Kammerdruck, einem Ventilöffnungsgrad einer automatischen Druckregeleinrichtung und einer Art und einer Durchflussrate von Gas, das einer Halbleiterfertigungsanlage (1) zugeführt wird;
eine Ausgabeeinheit für geschätzte Druckwerte (31c), die die Prozessdaten in ein Lernmodell (32b) eingibt, um einen geschätzten Druckwert auszugeben, wobei das Lernmodell (32b) so trainiert ist, dass es einen geschätzten Druckwert ausgibt, der von einem Vakuummessgerät (76) innerhalb eines Abgasrohrs (77), das zwischen ersten und zweiten Pumpen (74, 75) eines Abgassystems der Halbleiterfertigungsanlage (1) angeordnet ist, angezeigt werden soll, unter der Annahme, dass das Abgassystem vollständig normal ist, wenn Prozessdaten eingegeben werden; und
eine Anomalie-Bestimmungseinheit (31d), die bestimmt, ob ein Zustand des Abgassystems ein abnormaler Zustand ist oder nicht, basierend auf dem geschätzten Druckwert innerhalb des Abgasrohrs (77).

8. Die Informationsverarbeitungsvorrichtung nach Anspruch 7, die Folgendes aufweist:
eine Erfassungseinheit für gemessene Druckwerte (31b), die einen gemessenen Druckwert erfasst, der von dem Vakuummessgerät (76) gemessen wird, das in der Halbleiterfertigungsanlage (1) vorgesehen ist;
die Anomalie-Bestimmungseinheit (31d), die bestimmt, ob der Zustand des Abgassystems ein abnormaler Zustand ist oder nicht, basierend auf dem geschätzten Druckwert und dem gemessenen Druckwert;
eine Differenz-Erfassungseinheit, die kontinuierlich eine Differenz zwischen dem geschätzten Druckwert und dem gemessenen Druckwert erfasst;
eine Zeitreihendaten-Erstellungseinheit (31f), die Zeitreihendaten erstellt, in denen die Differenz und die Zeit einander zugeordnet sind;
eine Anzeigeeinheit, auf der die Zeitreihendaten erklärt werden; und
eine Zeit-Vorhersageeinheit (31h), die einen Zeitpunkt vorhersagt, zu dem die Differenz gleich einem vorbestimmten Wert oder größer als dieser wird, basierend auf den Zeitreihendaten.

9. Die Informationsverarbeitungsvorrichtung nach Anspruch 7 oder 8, die die Prozessdaten-Erfassungseinheit (31a) aufweist, die die Prozessdaten während eines Anlagen-Leerlaufzustands vor einem Fertigungsprozess des Zuführens von Gas zu der Halbleiterfertigungsanlage (1) erfasst.

10. Ein Modellgenerierungsverfahren zum Generieren des Lernmodells (32b) nach einem der Ansprüche 1, 4 oder 7, das Folgendes aufweist:
Erfassen eines ersten Druckwerts eines Vakuummessgeräts (76), das innerhalb eines Abgasrohrs (77) vorgesehen ist, das zwischen ersten und zweiten Pumpen (74, 75) eines Abgassystems einer ersten Halbleiterfertigungsanlage (1) angeordnet ist;
Erfassen von ersten Trainingsdaten, die Prozessdaten aufweisen, die wenigstens zwei aufweisen von Kammerdruck, einem Ventilöffnungsgrad einer automatischen Druckregeleinrichtung und einer Art und einer Durchflussrate von Gas, das der ersten Halbleiterfertigungsanlage (1) zugeführt wird, und den erfassten ersten Druckwert;
Generieren, basierend auf den erfassten ersten Trainingsdaten, des Lernmodells (32b), das einen geschätzten Druckwert ausgibt, der von dem Vakuummessgerät (76) angezeigt werden soll, unter der Annahme, dass das Abgassystem der ersten Halbleiterfertigungsanlage (1) vollständig normal ist, wenn Prozessdaten eingegeben werden, die wenigstens zwei aufweisen von Kammerdruck, einem Ventilöffnungsgrad einer automatischen Druckregeleinrichtung und einer Art und einer Durchflussrate von Gas, das der ersten Halbleiterfertigungsanlage (1) zugeführt wird.

11. Das Modellgenerierungsverfahren zum Generieren des Lernmodells (32b) nach Anspruch 10, das Folgendes aufweist:
Erfassen eines zweiten Druckwerts eines Vakuummessgeräts (76), das innerhalb eines Abgasrohrs (77) vorgesehen ist, das zwischen ersten und zweiten Pumpen (74, 75) eines Abgassystems einer zweiten Halbleiterfertigungsanlage (1B) angeordnet ist;
Erfassen von zweiten Trainingsdaten, die Prozessdaten aufweisen, die wenigstens zwei aufweisen von Kammerdruck, einem Ventilöffnungsgrad einer automatischen Druckregeleinrichtung und einer Art und einer Durchflussrate von Gas, das der zweiten Halbleiterfertigungsanlage (1B) zugeführt wird, und den erfassten zweiten Druckwert, wobei die zweiten Trainingsdaten in ihrer Menge geringer sind als die ersten Trainingsdaten; und
Feinabstimmen des ersten Lernmodells (32b) basierend auf den erfassten zweiten Trainingsdaten zum Generieren eines zweiten Lernmodells (32b), das einen geschätzten Druckwert ausgibt, der von dem Vakuummessgerät (76) der zweiten Halbleiterfertigungsanlage (1B) angezeigt werden soll, unter der Annahme, dass das Abgassystem der zweiten Halbleiterfertigungsanlage (1B) vollständig normal ist, wenn Prozessdaten eingegeben werden, die wenigstens zwei aufweisen von Kammerdruck, einem Ventilöffnungsgrad einer automatischen Druckregeleinrichtung und einer Art und einer Durchflussrate von Gas, das der zweiten Halbleiterfertigungsanlage (1B) zugeführt wird.

## Revendications

1. Programme amenant un ordinateur à exécuter un traitement de :
acquisition de données de processus comportant au moins deux parmi la pression d'une chambre, le degré d'ouverture d'une vanne d'un dispositif de régulation automatique de la pression, et le type et le débit d'un gaz fourni à un équipement de fabrication de semiconducteurs (1) ;
fourniture des données de processus à l'entrée d'un modèle d'apprentissage (32b) pour fournir en sortie une valeur de pression estimée, le modèle d'apprentissage (32b) étant entraîné de sorte à fournir en sortie une valeur de pression estimée, qui est destinée à être indiquée par un vacuomètre (76), à l'intérieur d'un tuyau d'échappement (77) situé entre des première et deuxième pompes (74, 75) d'un système d'échappement de l'équipement de fabrication de semiconducteurs (1), en supposant que le système d'échappement est entièrement normal, si des données de processus sont fournies en entrée ;
et de détermination de si un état du système d'échappement est un état anormal ou non sur la base de la valeur de pression estimée à l'intérieur du tuyau d'échappement (77).

2. Programme selon la revendication 1, amenant l'ordinateur à exécuter un traitement de :
acquisition d'une valeur de pression mesurée par le vacuomètre (76) prévu dans l'équipement de fabrication de semiconducteurs (1) ;
détermination de si l'état du système d'échappement est anormal ou non sur la base de la valeur de pression estimée et de la valeur de pression mesurée ;
acquisition en continu d'une différence entre la valeur de pression estimée et la valeur de pression mesurée ;
création de données chronologiques dans lesquelles la différence et le temps sont associés l'une à l'autre ;
affichage des données chronologiques sur une unité d'affichage ; et
prédiction d'un moment où la différence devient égale ou supérieure à une valeur prédéterminée sur la base des données chronologiques.

3. Programme selon la revendication 1 ou 2, amenant l'ordinateur à exécuter un traitement d'acquisition des données de processus pendant un état d'inactivité de l'équipement avant un processus de fabrication de fourniture de gaz à l'équipement de fabrication de semiconducteurs (1).

4. Procédé de traitement de l'information comprenant : l'acquisition de données de processus comportant au moins deux parmi la pression d'une chambre, le degré d'ouverture d'une vanne d'un dispositif de régulation automatique de la pression, et le type et le débit d'un gaz fourni à un équipement de fabrication de semiconducteurs (1) ;
la fourniture des données de processus à l'entrée d'un modèle d'apprentissage (32b) pour fournir en sortie une valeur de pression estimée, le modèle d'apprentissage (32b) étant entraîné de sorte à fournir en sortie une valeur de pression estimée, qui est destinée à être indiquée par un vacuomètre (76), à l'intérieur d'un tuyau d'échappement (77) situé entre des première et deuxième pompes (74, 75) d'un système d'échappement de l'équipement de fabrication de semiconducteurs (1), en supposant que le système d'échappement est entièrement normal, si des données de processus sont fournies en entrée ; et
la détermination de si un état du système d'échappement est un état anormal ou non sur la base de la valeur de pression estimée à l'intérieur du tuyau d'échappement (77).

5. Procédé de traitement d'informations selon la revendication 4, comprenant :
l'acquisition d'une valeur de pression mesurée par le vacuomètre (76) prévu dans l'équipement de fabrication de semiconducteurs (1) ;
la détermination de si l'état du système d'échappement est anormal ou non sur la base de la valeur de pression estimée et de la valeur de pression mesurée ;
l'acquisition en continu d'une différence entre la valeur de pression estimée et la valeur de pression mesurée ;
la création de données chronologiques dans lesquelles la différence et le temps sont associés l'une à l'autre ;
l'affichage des données chronologiques sur une unité d'affichage ; et
la prédiction d'un moment où la différence devient égale ou supérieure à une valeur prédéterminée sur la base des données chronologiques.

6. Procédé de traitement d'informations selon la revendication 4 ou 5, comprenant l'acquisition des données de processus pendant un état d'inactivité de l'équipement avant un processus de fabrication de fourniture de gaz à l'équipement de fabrication de semiconducteurs (1).

7. Dispositif de traitement d'informations, comprenant : une unité d'acquisition de données de processus (31a) qui acquiert des données de processus comportant au moins deux parmi la pression de la chambre, le degré d'ouverture d'une vanne d'un dispositif de commande automatique de la pression et le type et le débit d'un gaz fourni à un équipement de fabrication de semiconducteurs (1) ;
une unité de sortie de valeur de pression estimée (31c) qui fournit les données de processus à l'entrée d'un modèle d'apprentissage (32b) pour fournir en sortie une valeur de pression estimée, le modèle d'apprentissage (32b) étant entraîné de sorte à fournir en sortie une valeur de pression estimée, qui est destinée à être indiquée par un vacuomètre (76), à l'intérieur d'un tuyau d'échappement (77) situé entre des première et deuxième pompes (74, 75) d'un système d'échappement de l'équipement de fabrication de semiconducteurs (1), en supposant que le système d'échappement est entièrement normal, si des données de processus sont fournies en entrée ; et
une unité de détermination d'anomalie (31d) qui détermine si l'état du système d'échappement est anormal ou non, sur la base de la valeur de pression estimée à l'intérieur du tuyau d'échappement (77).

8. Dispositif de traitement d'informations selon la revendication 7, comprenant :
une unité d'acquisition de valeur de pression mesurée (31b) qui acquiert une valeur de pression mesurée par le vacuomètre (76) prévu dans l'équipement de fabrication de semiconducteurs (1) ;
l'unité de détermination d'anomalie (31d) qui détermine si l'état du système d'échappement est un état anormal ou non sur la base de la valeur de pression estimée et de la valeur de pression mesurée ;
une unité d'acquisition de différence qui acquiert en continu une différence entre la valeur de pression estimée et la valeur de pression mesurée ;
une unité de création de données chronologiques (31f) qui crée des données chronologiques dans lesquelles la différence et le temps sont associés l'une à l'autre ;
une unité d'affichage sur laquelle les données chronologiques sont présentées ; et
une unité de prédiction temporelle (31h) qui prédit un moment où la différence devient égale ou supérieure à une valeur prédéterminée sur la base des données chronologiques.

9. Dispositif de traitement d'informations selon la revendication 7 ou 8, comprenant l'unité d'acquisition de données de processus (31a) qui acquiert les données de processus pendant un état d'inactivité de l'équipement avant un processus de fabrication de fourniture de gaz à l'équipement de fabrication de semiconducteurs (1).

10. Procédé de génération de modèle de génération du modèle d'apprentissage (32b) selon l'une quelconque des revendications 1, 4 ou 7, comprenant :
l'acquisition d'une première valeur de pression du vacuomètre (76) prévu à l'intérieur d'un tuyau d'échappement (77) situé entre des première et deuxième pompes (74, 75) d'un système d'échappement d'un premier équipement de fabrication de semiconducteurs (1) ;
l'acquisition de premières données d'apprentissage comportant des données de processus comportant au moins deux parmi la pression d'une chambre, le degré d'ouverture d'une vanne d'un dispositif de commande automatique de la pression et le type et le débit d'un gaz fourni au premier équipement de fabrication de semiconducteurs (1) et la première valeur de pression acquise ;
la génération, sur la base des premières données d'apprentissage acquises, du modèle d'apprentissage (32b) qui fournit en sortie une valeur de pression estimée, qui est destinée à être indiquée par le vacuomètre (76), en supposant que le système d'échappement du premier équipement de fabrication de semiconducteurs (1) est entièrement normal, si des données de processus comportant au moins deux parmi la pression de la chambre, le degré d'ouverture d'une vanne d'un dispositif de commande automatique de la pression, et le type et le débit d'un gaz fourni au premier équipement de fabrication de semiconducteurs (1) sont fournies en entrée.

11. Procédé de génération de modèle de génération du modèle d'apprentissage (32b) selon la revendication 10, comprenant :
l'acquisition d'une deuxième valeur de pression d'un vacuomètre (76) prévu à l'intérieur d'un tuyau d'échappement (77) situé entre des première et deuxième pompes (74, 75) d'un système d'échappement d'un deuxième équipement de fabrication de semiconducteurs (1B) ;
l'acquisition de deuxièmes données d'apprentissage comportant des données de processus comportant au moins deux parmi la pression de la chambre, le degré d'ouverture de la vanne du dispositif de commande automatique de la pression et le type et le débit du gaz fourni au deuxième équipement de fabrication de semiconducteurs (1B) et la deuxième valeur de pression acquise, dans lequel les deuxièmes données d'apprentissage sont en quantité plus faibles que les premières données d'apprentissage ; et
le réglage affiné du premier modèle d'apprentissage (32b) sur la base des deuxièmes données d'apprentissage acquises pour générer un deuxième modèle d'apprentissage (32b) qui fournit en sortie une valeur de pression estimée, qui est destinée à être indiquée par le vacuomètre (76) du deuxième équipement de fabrication de semiconducteurs (1B), en supposant que le système d'échappement du deuxième équipement de fabrication de semiconducteurs (1B) est entièrement normal, si des données de processus comportant au moins deux parmi la pression de la chambre, un degré d'ouverture de la vanne du dispositif de régulation automatique de la pression et un type et un débit du gaz fourni au deuxième équipement de fabrication de semiconducteurs (1B) sont fournies en entrée.
